Europäisches Patentamt

European Patent Office

Office européen des brevets

(19)

(11) **EP 0 370 403 B1**

(12)

# EUROPEAN PATENT SPECIFICATION

(45) Date of publication and mention
of the grant of the patent:
**03.09.1997 Bulletin 1997/36**

(51) Int Cl.[6]: **H01L 29/205**, H01L 29/15,
H01L 29/06, H01L 29/88,
H01L 29/76

(21) Application number: **89121301.9**

(22) Date of filing: **17.11.1989**

(54) **Semiconductor having the coupled quantum box array structure**

Halbleiter mit einer Matrixstruktur aus gekoppelten Quanten-Schachteln

Semi-conducteur ayant une structure de matrice à boîtes quantiques couplées

(84) Designated Contracting States:
**DE GB**

(30) Priority: **19.11.1988 JP 293336/88**

(43) Date of publication of application:
**30.05.1990 Bulletin 1990/22**

(73) Proprietor: **RESEARCH DEVELOPMENT
CORPORATION OF JAPAN
Chiyoda-ku Tokyo 100 (JP)**

(72) Inventor: **Sakaki, Hiroyuki
Yokohama-shi Kanagawa 227 (JP)**

(74) Representative: **VOSSIUS & PARTNER
Postfach 86 07 67
81634 München (DE)**

(56) References cited:
EP-A- 283 276          EP-A- 0 170 044
US-A- 4 503 447        US-A- 4 591 889

• **SOLID STATE TECHNOLOGY, vol. 28, no. 10,
October 1985, pages 125-129, Washington, New
York, US; C.F. COOK, Jr. et al.: "Lithography for
ultra-submicron device structures"**
• **THIN SOLID FILMS, vol. 36, 1976, pages 497-501,
Elsevier Sequoia, S.A., Lausanne, CH; H.
SAKAKI et al.: "Possible applications of
surface-corrugated quantum thin films to
negative-resistance devices"**
• **JAPANESE JOURNAL OF APPLIED
PHYSICS/PART 2, vol. 28, no. 2, February 1989,
pages L314-L316, Tokyo, JP; H. SAKAKI:
"Quantum wire superlattices and coupled
quantum box arrays: A novel method to
suppress optical phonon scattering in
semiconductors"**

## Description

The present invention relates to a semiconductor having the coupled quantum box array structure to suppress optical phonon scattering by incorporating artificial structure in semiconductor.

A semiconductor device having quantum box structure is disclosed in EP-A-0 170 044. This device has a switching function where electrons can resonantly tunnel through the barrier only when the discrete quantized states in two quantum boxes coincide by the applied bias. Some phonon scattering process of electrons can participate in this tunnelling.

A method for the formation of quantum box arrays is shown in US-A-4 503 447. In this device, quantum boxes are formed by the use of different barrier material which has larger bandgap in the quantum film.

EP-A-0 283 276 relates to a semiconductor device comprising a semiconductor heterostructure formed on a substrate, source and drain electrodes formed on the semiconductor heterostructure and a plurality of control electrodes arranged at predetermined positions between the source and drain electrodes at a predetermined spacing. The charge carriers, which can only freely move in the plane of the thin semiconductor well layer of the semiconductor heterostructure are further confined by the closely spaced control electrodes in a direction perpendicular to the source/drain direction so that one dimensional carrier paths are formed between the control electrodes in the source/drain direction.

The electrons in semiconductor contribute to the electric conduction and are utilized in transistor, for example. The electrons are scattered in the disturbed portion of the crystal and frequently change the directions. Therefore, when the electric field F is applied, the velocity v of the electron flow is not increased simply with the time elapsed, but it flows at a constant velocity determined by $\mu \times F$. Here, $\mu$ is a physical quantity called the electron mobility and is proportional to mean time interval T of the scattering.

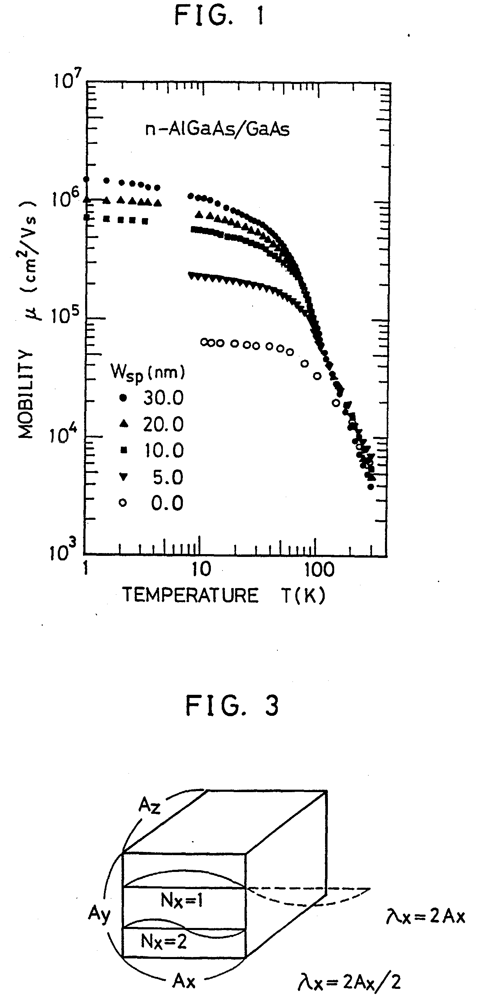

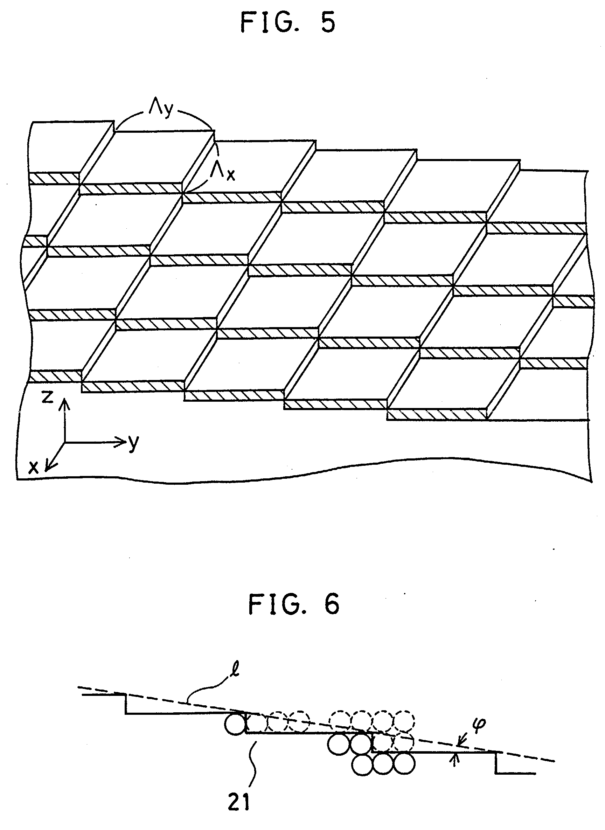

Fig. 1 shows the dependency of electron mobility on temperature in the case of n-type AlGaAs/GaAs hetero junction. As shown in Fig. 1 (See Physical Review, B condensed Matter, Volume 33, Third Series, Number 12-I, p. 82-97, Fig. 5.), the electron mobility $\mu$ rapidly decreases when temperature rises, and the decrease becomes very conspicuous when temperature increases to 100°K or more. Namely, when the temperature including room temperature exceeds 100°K, thermal vibration (called phonon or lattice vibration) occurs, in which the crystal lattice of the atom groups constituting the crystal lattice is vibrated, whereas it is known that the main cause of the above scattering is the slight disturbance of the lattice arrays caused by thermal vibration. The electron mobility is determined by this thermal vibration.

Particularly, in the polar semiconductor such as GaAs, the lattice vibration called optical phonon controls the scattering, and this determines the characteristics of the semiconductor devices such as FET.

In the past, it has been believed that the dependency of electric resistance on the temperature in semiconductor or metal was caused by the influence of the lattice vibration of the electrons and that it is unavoidable for the electrons to be placed under the influence of lattice vibration. Accordingly, it is essential to cool the semiconductor in order to eliminate the scattering, and the decline of the characteristics due to the temperature rise of semiconductor was suppressed by cooling.

It is an object of the present invention to suppress the optical phonon scattering, believed as unavoidable in the past, by incorporating artificial structure in semiconductor. Another object of this invention is to offer semiconductor of quantum structure, in which the dependency of semiconductor on temperature has been improved.

To attain the above objects, the present invention proposes a semiconductor device having a coupled quantum box array structure comprising quantum boxes and barriers whereby the electrons are confined within the quantum boxes and can move between the quantum boxes through the barriers by tunnel effect, and having a miniband structure whereby the width of the minibands is smaller than the optical phonon energy $E_{OP}$ and the the width of the mini gap between the miniband generated from the lowest energy level and that of the next lowest energy level is bigger than said optical phonon energy $E_{OP}$, and that most of the electrons are in the miniband state generated from the lowest energy level.

By providing the above state, in which the width of miniband and the width of gap are in specific term with the electron state and the electrons can move between the quantum boxes by tunnel effect, it is possible to confine the electrons in the quantum box while enabling the electric conduction and to suppress the lattice vibration. Thus, the dependency of the electron mobility in semiconductor on temperature can be improved.

Still other objects and advantages of the invention will in part be obvious and will in part be apparent from the specification.

The invention accordingly comprises the features of construction, combinations of elements, and arrangement of parts which will be exemplified in the construction hereinafter set forth, and the scope of the invention will be indicated in the claims.

BRIEF DESCRIPTION OF THE DRAWINGS

Fig. 1 is a diagram showing the dependency of electron mobility on temperature in n-type AlGaAs/GaAs hetero junction;

Fig. 2 shows an embodiment of the semiconductor having coupled quantum box array structure according to this invention;

Fig. 3 is a drawing to explain the standing wave in the quantum box;

Fig. 4 shows another embodiment of the semiconductor having coupled quantum box array structure of this invention;

Fig. 5 gives an example of 2-dimensional step structure;

Fig. 6 is a drawing to explain the method to prepare the periodic step structure;

and Fig. 7 is a drawing to explain the method to prepare the quantum well device using the crystal growth method.

DESCRIPTION OF PREFERRED EMBODIMENTS

In the following, description will be given on the embodiments of the invention in connection with the drawings.

As the semiconductor devices of the new concept using thin film growth technique such as molecular beam epitaxy method, organic metal CVD method, etc., the elements using quantum thin film such as quantum well laser, quantum wire laser, quantum box laser, etc. have been proposed (e.g. "Applied Physics", Volume 52, No. 10 (1983), pp. 852 - 856). In these devices, the electrons are confined in the direction of thickness by providing the active layer as the quantum thin film with the same thickness (approx. 100 Å) as the wavelength of de Broglie wave of electron so that the electrons can behave as free particles only in 2-dimensional direction along thin film.

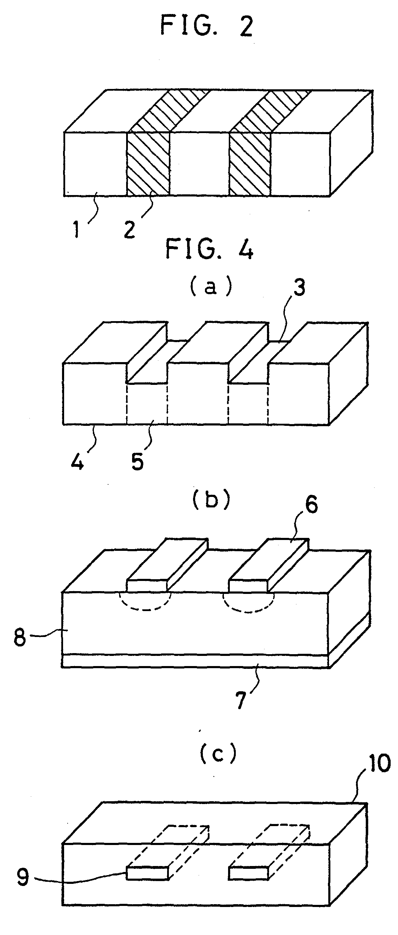

The present invention uses the quantum box, in which the lateral dimension of the above quantum thin film is reduced, as basic structure. In the example of the semiconductor having the coupled quantum box array structure as shown in Fig. 2, the quantum boxes 1 are aligned at adjacent positions with the barriers 2 of different material therebetween. By providing such structure and satisfying a certain condition, the phonon scattering is suppressed in quantum boxes, and the electrons can move between the quantum boxes 1 through the barriers 2 by tunnel effect. The conditions for this are:

(1) By the tunnel effect between the quantum boxes, the energy level is extended to a certain extent (miniband), whereas the width $E_b$ of miniband is smaller than the optical phonon energy $E_{OP}$;

(2) The gap $E_g$ between the miniband generated from the lowest energy level and the miniband generated from the next lowest energy level is bigger than $E_{OP}$;

(3) Most of the electrons are in the state of the lowest miniband.

In the following, the behavior of the semiconductor having the coupled quantum box array structure is described.

In the scattering of electrons by optical phonon, the optical phonon energy $E_{OP}$ is absorbed or released, and the electron energy E is increased or decreased by $E_{OP}$. Namely, when lattice vibration is generated by giving (releasing) energy through the collision of electrons caused by scattering, the energy of the electrons is changed to $E - E_{OP}$. On the contrary, if energy is absorbed, it is changed to $E + E_{OP}$. Incidentally, the energy $E_{OP}$ is about 30 meV, and this value approximately corresponds to thermal energy when the electrons are moving. Therefore, if the giving and the taking of the energy are stopped, the phonon scattering can be suppressed.

Suppose that there is a quantum box having the dimensions $A_x$, $A_y$ and $A_z$ along the axes X, Y and Z as shown in Fig. 3. If $A_x > A_y > A_z$, the standing waves of the electrons are generated when the electrons are confined in the boxes. As the result, the wavelength $\lambda$ is allowed to have only intermittent value corresponding to the number of the peaks of the standing wave. For example, it is:

$$\lambda_x = 2A_x/N_x$$

to "x" direction. Here, $N_x$ is the number of quanta (i.e. the number of the peaks of the standing wave as shown in Fig. 3) and it is integral number (1, 2, 3, .....). The same applies to "y" direction and "z" direction.

If the momentum $P_x$ of the electron has Planck constant h,

$$P_x = h/\lambda_x$$

Therefore, the energy E is expressed by:

$$E(N_x, N_y, N_z)$$

$$= (1/2m)(P_x{}^2 + P_y{}^2 + P_z{}^2)$$

$$= (\frac{h^2}{2m})\{(\frac{N_x}{2A_x})^2 + (\frac{N_y}{2A_y})^2 + (\frac{N_z}{2A_z})^2\}$$

That is, it is obtained by dividing the square of the momentum by 2m (m: Mass). Since the numbers of quanta $N_x$, $N_y$ and $N_z$ are integral numbers, the energy E has intermittent value.

Accordingly, the electron has the lowest quantum energy when there is one peak of the standing wave in each direction. That is:

E (1, 1, 1).

The next lowest energy status occurs when one of $N_x$, $N_y$ and $N_z$ is turned to 2. If $A_x > A_y > A_z$ in this case,

E (2, 1, 1).

When the electrons are in the lowest quantum energy status and the gap $E_g$ to the next lowest energy status is bigger than the optical phonon energy $E_{OP}$, the movement between quantum states by phonon is suppressed. However, since the electrons in the quantum boxes cannot move, there is no contribution to electric conduction.

If only $A_x$ is extended, the quantum wire or fine line is generated, and this enables the conduction in "x" direction. However, if $A_x$ is extended too much, the energy gap in the status:

$$N_x = 1, 2, 3, .....$$

is extremely decreased. Thus, discrete property of energy is lost and quasi-continuous energy status is allowed, making the suppression of phonon scattering impossible. To overcome this dilemma, it is preferable to use the intermediate structure between quantum box and quantum fine line (i.e. coupled quantum box array structure). Specifically, it is proposed to use the structure, in which the quantum boxes are aligned at adjacent positions and the electrons can move between them by tunnel effect, i.e. the use of quantum fine line superlattice is preferable. However, the energy state allowed in this case must satisfy the conditions as described above. That is:

(1) By the tunnel effect between the quantum boxes, the energy level is extended to a certain extent (miniband), whereas the width $E_b$ of miniband is smaller than $E_{OP}$.

Namely, if the width $E_b$ of miniband is smaller than $E_{OP}$, it cannot be turned to the state where $E_{OP}$ is absorbed or released by lattice vibration;

(2) The $E_g$ between the miniband generated from the lowest energy level and the miniband generated from the next lowest energy level is bigger than $E_{OP}$;

Namely, in case there are the miniband generated from the lowest energy level with only one peak of the standing wave and the miniband generated from the next lowest energy level with two peaks in one direction, it is not possible to move to the other miniband by changing the shape of the peak even when $E_{OP}$ is absorbed or released by lattice vibration if the gap $E_g$ is bigger than $E_{OP}$.

(3) Most of the electrons are in the state of the lowest miniband.

Under these conditions, it is possible to generate the status, which contributes to electric conduction but does not receive lattice vibration.

Fig. 4 shows another embodiment of the semiconductor having coupled quantum box array structure of the present invention, where 3 represents a groove, 4 a quantum box, 5 a barrier, 6 and 7 control electrodes, 8 and 10 quantum thin films, and 9 a control electrode.

In the example shown in Fig. 4 (a), a groove 3 is provided instead of the barrier of Fig. 2, and this forms a barrier 5 to hinder the passage of electrons, and the quantum boxes 4 and the barriers 5 are arranged one after another. That is, the film thickness is controlled. In the example shown in Fig. 4 (b), a control electrode 6 is placed on the quantum thin film 8 to form the layer, which hinders the passage of the electrons. In the example of Fig. 4 (c), a different material or a control electrode 9 is arranged in the quantum thin film 10.

As it is evident from the embodiments as described above, the semiconductor with the coupled quantum box array structure of the present invention has such structure that the layers allowing easier existence of the electrons as the standing wave are arranged at the adjacent positions to the layers hindering the passage of the electrons. Therefore, it can have the structure consisting of quantum boxes and barriers as shown in Fig. 2 or the structure as shown in Fig. 4, and further, the other structure equivalent to these.

There have been various proposals to prepare the quantum structure. In the following, description will be given to a part of a separate application by the present inventor (Japanese Patent Application Sho 63-168068).

In Fig. 6, the substrate 21 denotes a crystal of GaAs. When this is polished at a specific angle $\phi$ from a specific orientation of the crystal, the periodic step structure as shown is obtained. If this is composed of the atom layers consisting of o, the atoms of o shown by dotted line are scraped off by polishing, the step structure corresponding to the thickness of the atom layer can be formed. Namely, because an atom cannot be polished partially, the portion partially involved in polishing (o shown by dotted line) is scraped off, and the graded step occurs according to each atom. Therefore, the step width varies according to the polishing angle. It is narrowed down as the angle $\phi$ increases, and it is widened as the angle decreases. For example, with the angle $\phi$ and the step width $\Lambda$, the following relationship is obtained.

| ø (°) | 0.5 | 0.8 | 1 | 1.6 | 2 |
|---|---|---|---|---|---|
| $\Lambda$ (Å) | 320 | 200 | 160 | 100 | 80 |

Also, it is possible to form the 2-dimensional step structure as shown in Fig. 5 according to the polishing direction.

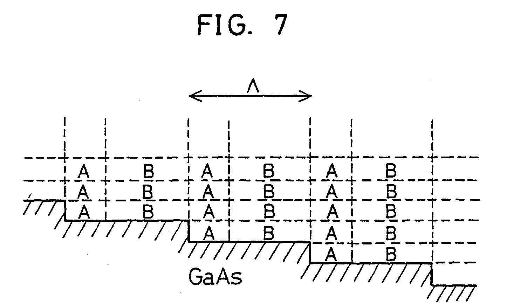

When the materials A and B are deposited as shown in Fig. 7 on the substrate 21 thus prepared, the crystal with different compositions in longitudinal direction can be formed. Specifically, when the material A is deposited for the thickness of several atoms, junction occurs on two faces of the bottom and the side at the corner of the step, and the crystal is formed sequentially from this corner. Accordingly, by inserting and depositing the material A, it is possible to form the structure as shown in Fig. 3 (c).

The present invention is not limited to the above embodiments, and it is possible to conceive various variations. For example, description was given in the above on the structure where quantum boxes are aligned in 1-dimensional direction, whereas the quantum boxes may be aligned within a plane or stereoscopically as far as the above conditions are met.

As it is evident from the above description, it is possible by the present invention to suppress the phonon scattering without losing the discrete property of energy, to suppress the optical phonon scattering, believed as unavoidable in the past, because the intermediate structure between quantum box and quantum fine line (coupled quantum box array structure) contributing to electric conduction is used, and to extensively improve the dependency of electron mobility on temperature in semiconductor.

## Claims

1. A semiconductor device having a coupled quantum box array structure, provided with a quantum box array structure comprising quantum boxes (1, 4) and barriers (2, 5), whereby the electrons are confined within the quantum boxes and can move between the quantum boxes through the barriers (2, 5) by tunnel effect; and having a miniband structure whereby

   the width of the minibands is smaller than the optical phonon energy $E_{OP}$, and
   the width of the minigap between the miniband generated from the lowest energy level and the miniband generated from the next lowest energy level is bigger than said optical phonon energy $E_{OP}$,

   wherein most of the electrons are in the miniband generated from the lowest energy level.

2. A semiconductor having coupled quantum box array structure as set forth in Claim 1, wherein the quantum boxes are formed in a quantum thin film, and grooves (3) are provided in the quantum thin film (8, 10) forming the barriers.

3. A semiconductor having coupled quantum box array structure as set forth in Claim 1 or 2, wherein the quantum boxes are formed in a quantum thin film, and a control electrode (6) is provided on the quantum thin film (8) to form the barriers.

4. A semiconductor having coupled quantum box array structure as set forth in any of Claims 1 to 3, wherein the quantum boxes are formed in a quantum thin film, and the barriers are formed by regions in the quantum thin film made of a different material than that of the quantum thin film or by a control electrode (9) on the quantum thin film.

# EP 0 370 403 B1

**Patentansprüche**

1. Halbleiterbauelement mit einer Matrixstruktur aus gekoppelten Quantenschachteln, das mit einer Quantenschachtel-Matrixstruktur mit Quantenschachteln (1, 4) und Barrieren (2, 5) versehen ist, durch die die Elektronen in den Quantenschachteln eingeschlossen sind und sich zwischen den Quantenschachteln durch die Barrieren (2, 5) hindurch infolge des Tunneleffekts bewegen können; sowie mit einer Minibandstruktur, durch die die Breite der Minibänder kleiner als die optische Phononenenergie $E_{OP}$ ist, und die Breite der Minilücke zwischen dem anhand des niedrigsten Energieniveaus erzeugten Miniband und dem anhand des nächstniedrigsten Energieniveaus erzeugten Miniband größer als die optische Phononenenergie $E_{OP}$ ist, wobei sich die meisten Elektronen in dem anhand des niedrigsten Energieniveaus erzeugten Miniband befinden.

2. Halbleiterbauelement mit einer Matrixstruktur aus gekoppelten Quantenschachteln nach Anspruch 1, wobei die Quantenschachteln in einem Quantendünnfilm ausgebildet und die Barrieren bildende Rillen (3) in dem Quantendünnfilm (8, 10) vorgesehen sind.

3. Halbleiterbauelement mit einer Matrixstruktur aus gekoppelten Quantenschachteln nach Anspruch 1 oder 2, wobei die Quantenschachteln in einem Quantendünnfilm ausgebildet sind und eine Steuerelektrode (6) auf dem Quantendünnfilm (8) vorgesehen ist, um die Barrieren zu bilden.

4. Halbleiterbauelement mit einer Matrixstruktur aus gekoppelten Quantenschachteln nach einem der Ansprüche 1 bis 3, wobei die Quantenschachteln in einem Quantendünnfilm ausgebildet und die Barrieren durch Bereiche in dem Quantendünnfilm ausgebildet sind, die aus einem anderen Material als dem des Quantendünnfilms oder durch eine Steuerelektrode (9) auf dem Quantendünnfilm gebildet sind.

**Revendications**

1. Dispositif à semi-conducteurs comportant une structure de matrice à boîtes quantiques couplées, muni d'une structure de matrice à boîtes quantiques comprenant des boîtes quantiques (1, 4) et des barrières (2, 5) de sorte que les électrons sont confinés à l'intérieur des boîtes quantiques et peuvent se déplacer entre les boîtes quantiques à travers les barrières (2, 5) par effet de tunnel ; et comportant une structure de minibande dans laquelle la largeur des minibandes étant inférieure à l'énergie phonon optique $E_{op}$, et

la largeur du mini-espace entre la minibande généré par le niveau d'énergie le plus bas et la minibande générée par le niveau d'énergie immédiatement inférieur est supérieure à l'énergie phonon optique $E_{op}$, dans lequel la plupart des électrons se situent dans la minibande générée par le niveau d'énergie le plus bas.

2. Semi-conducteur comportant une structure de matrice à boîtes quantiques selon la revendication 1, dans lequel les boîtes quantiques sont formées dans un film quantique mince et les gorges (3) sont prévues dans un film quantique mince (8, 10) formant des barrières.

3. Semi-conducteur comportant une structure de matrice à boîtes quantiques couplées selon la revendication 1 ou 2, dans lequel les boîtes quantiques sont formées dans un film quantique mince et une électrode de commande (6) est prévue sur le film quantique mince (8) pour former des barrières.

4. Semi-conducteur comportant une structure de matrice à boîtes quantiques couplées selon l'une quelconque des revendications 1 à 3, dans lequel les boîtes quantiques sont formées dans un film quantique mince et les barrières sont formées par des régions dans le film quantique mince réalisées à partir d'un matériau différent de celui du film quantique mince ou par une électrode de commande (9) sur le film quantique mince.

# FIG. 1

# FIG. 3

# FIG. 2

# FIG. 4

## ( a )

## ( b )

## ( c )

FIG. 5

FIG. 6

# FIG. 7